# EUROPÄISCHE PATENTSCHRIFT

(11) **EP 3 705 643 B1**
(45) Veröffentlichungstag und Bekanntmachung des Hinweises auf die Patenterteilung: **15.09.2021**
(21) Anmeldenummer: 20161134.0
(22) Anmeldetag: 05.03.2020
(51) Int. Cl.: E03C 1/05, G05G 1/10, H03K 17/97, E03C 1/04, G05G 5/06, G05G 1/02, H01H 25/06

(54) **BEDIENVORRICHTUNG FÜR EINE WASSERFÜHRENDE SANITÄRE ARMATUR**
OPERATING DEVICE FOR A WATER-BEARING SANITARY FITTING
DISPOSITIF DE FONCTIONNEMENT POUR UNE ARMATURE SANITAIRE À CIRCULATION D'EAU

(30) Priorität: 08.03.2019 DE 102019203170
(43) Veröffentlichungstag der Anmeldung: 09.09.2020
(73) Patentinhaber: Hansgrohe SE, 77761 Schiltach (DE)
(72) Erfinder: BAUMSTARK, Lars, 79110 Freiburg (DE); GEBERT, Aline, 78733 Aichhalden (DE)
(74) Vertreter: Patentanwälte Ruff, Wilhelm, Beier, Dauster & Partner mbB

(56) Entgegenhaltungen:
- EP-A1- 3 048 084
- EP-A1- 3 048 627
- WO-A1-2009/103596
- US-A1- 2008 259 056
- US-A1- 2013 113 465

## Beschreibung

Die Erfindung bezieht sich auf eine Bedienvorrichtung für eine wasserführende sanitäre Armatur, die eine ortsfest befestigte oder befestigbare Basishalterung und einen an der Basishalterung angeordneten Bedienknebel aufweist. Der Bedienknebel weist mindestens zwei Teile auf, nämlich mindestens ein Dreh-Bedienteil und mindestens ein Fest-Bedienteil, die gegeneinander verdrehbar sind.

Eine Bedienvorrichtung der eingangs genannten Art ist in den Patentschriften EP 2 250 321 B1 und EP 2 267 232 B1 offenbart. Bei der EP 2 250 321 B1 kann ein zum Drehen ausgebildetes Bedienelement mittels einer Hubbewegung in eine zweite Funktionsebene gebracht werden.

In der EP 3 048 627 A1 ist eine weitere Bedienvorrichtung offenbart, bei der ein Teil eines Bedienelements, das im oberen Bereich angeordnet ist, horizontal bzw. linear verschoben werden kann. Dieses Verschieben erfolgt mittels einer Horizontalführung.

Eine weitere Bedienvorrichtung ist in der US 2013/0113465 A1 offenbart. Diese weist ein mittleres feststehendes Teil mit einer Leuchtanzeige auf. Um diesen mittleren Teil herum ist ein Dreh-Bedienteil angeordnet zur Einstellung eines bestimmten Wertes. Für die Erfassung der Bewegung ist ein 3D-Hallsensor vorgesehen.

Eine nochmals weitere Bedienvorrichtung für eine Dusche ist aus der US 2008/0259056 A1 bekannt. Sie weist ein großes Display auf, unter dem ein Bedienelement zur Auswahl und zur Bestätigung angeordnet ist.

In der EP 3 048 084 A ist eine Bedienvorrichtung als Fernbedienung für ein Filtersystem in der Wasserversorgung einer Küchenarmatur als drehbarer Bedienknebel ausgebildet. Der Bedienknebel ist abnehmbar neben einer Küchenspüle angeordnet.

Der Erfindung liegt als technisches Problem die Bereitstellung einer Bedienvorrichtung der eingangs genannten Art zugrunde, die eine Bedienung einer wasserführenden sanitären Armatur verbessert und sehr komfortabel ermöglicht, wobei insbesondere deren Bedienknebel signifikante Anwendungsvorteile bietet.

Die Erfindung löst dieses Problem durch die Bereitstellung einer Bedienvorrichtung für eine wasserführende sanitäre Armatur mit den Merkmalen des Anspruchs 1. Bei dieser Bedienvorrichtung sind eine ortsfest befestigte oder befestigbare Basishalterung und ein an der Basishalterung angeordneter Bedienknebel vorgesehen. Der Bedienknebel weist mindestens zwei Teile auf, nämlich mindestens ein Dreh-Bedienteil und mindestens ein Fest-Bedienteil, wobei Dreh-Bedienteil und Fest-Bedienteil gegeneinander verdrehbar sind.

Dabei ist zumindest der Dreh-Bedienteil des Bedienknebels an der Basishalterung um eine Drehachse drehbar, kann also gedreht werden. Vorteilhaft kann er um eine Drehachse senkrecht zu einer Wand oder Unterlage gedreht werden, an der er befestigt ist. Zumindest ein Teil des Bedienknebels kann aus einer Grund-Stellung entlang der Drehachse gegen eine Federkraft einer Feder eingedrückt werden auf die Basishalterung zu in eine Eindrück-Stellung. Diese kann durch einen Anschlag als Eindrück-Anschlag genau definiert werden. Die Feder drückt den Bedienknebel mit der Federkraft von der Eindrück-Stellung in die Grund-Stellung, kann ihn also zurückdrücken. So bewegt er sich nach einem Eindrücken selbsttätig wieder zurück bzw. wieder heraus. In der Basishalterung ist mindestens ein Drück-Magnet angeordnet, der vorteilhaft als Permanentmagnet ausgebildet ist. Im eindrückbaren Teil des Bedienknebels ist mindestens ein Magnetfeldsensor angeordnet, vorteilhaft ein Hallsensor.

Für den Magnetfeldsensor ist eine Auswertevorrichtung in der Bedienvorrichtung bzw. im Bedienknebel vorgesehen, die dazu ausgebildet ist, erkennen zu können, ob sich der Magnetfeldsensor beim Eindrücken des eindrückbaren Teils des Bedienknebels an den Drück-Magnet annähert oder davon entfernt. So kann das Eindrücken des eindrückbaren Teils erkannt werden bzw. dessen Stellung in Richtung auf die Basishalterung zu. Des Weiteren ist im Dreh-Bedienteil des Bedienknebels mindestens ein Magnetelement angeordnet, vorteilhaft mehrere. Sie können dazu verwendet werden, eine Drehung des Bedienteils bzw. des Bedienknebels zu erkennen, vorteilhaft wiederum über einen Magnetfeldsensor.

Erfindungsgemäß ist der Drück-Magnet drehbar gelagert um eine eigene Achse, die der Drehachse des Dreh-Bedienteils entspricht bzw. auf ihr liegt. Somit liegt der Drück-Magnet zentrisch zum Dreh-Bedienteil. Der Drück-Magnet soll mit dem Magnetelement derart wechselwirken, dass sich der Drück-Magnet mit einer Drehung des Magnetelements samt dem Dreh-Bedienteil des Bedienknebels mitdreht. Somit soll der Drück-Magnet immer dieselbe Stellung relativ zu dem mindestens einen Magnetelement oder zu allen Magnetelementen aufweisen, die gedreht werden können. Dadurch kann es erreicht werden, dass das zwischen ihnen ausgebildete Magnetfeld immer gleich ist, unabhängig von der Dreh-Stellung des Bedienknebels bzw. des Dreh-Bedienteils. Das ermöglicht es dem vorgenannten Magnetfeldsensor, besonders genau und störungsfrei eine Annäherung an den Drück-Magnet zu erkennen, und unabhängig von einer Drehung bzw. vor allem auch von einer Drehung des Dreh-Bedienteils zwischen den beiden Stellungen zu unterscheiden.

In einer Weiterbildung der Erfindung ist der Drück-Magnet rotationssymmetrisch ausgebildet. Vorteilhaft ist er als Scheibe oder als Kreisring ausgebildet. Die Drehachse des Dreh-Bedienteils kann durch einen Mittelpunkt und Rotationssymmetriepunkt des Drück-Magneten verlaufen, wobei bevorzugt die beiden Drehachsen zusammenfallen bzw. gleich sind.

In einer vorteilhaften Weiterbildung der Erfindung kann der Drück-Magnet in Richtung entlang der Drehachse, also auf die Basishalterung zu, maximal 1 mm bzw. 25% des Bewegungswegs des Bedienknebels beim Drücken auf die Basishalterung zu bewegt werden. Dieses Spiel sollte aber vorteilhaft möglichst gering sein, so dass es zwar ein leichtgängiges Drehen des Drück-Magneten erlaubt, aber keine nennenswerte Bewegung des Drück-Magneten auf den Magnetfeldsensor zu ermöglicht. Besonders vorteilhaft ist der Drück-Magnet in Richtung entlang der Drehachse gar nicht bewegbar. Eine Drehbarkeit des Drück-Magneten kann durch entsprechende Materialien, vorteilhaft Beschichtungen, verbessert werden, insbesondere innerhalb einer Aufnahme für den Drück-Magnet an bzw. in der Basishalterung.

In einer Ausgestaltung der Erfindung ist der als Permanentmagnet ausgebildete Drück-Magnet diametral magnetisiert, so kann seine Nord-Süd-Richtung in einer Richtung senkrecht zur Drehachse verlaufen. Bei einem Drück-Magnet in Ringform kann eine Hälfte des Rings einen Nordpol bilden, und die andere Hälfte des Rings bildet dann einen Südpol.

In weiterer Ausgestaltung der Erfindung ist das mindestens eine Magnetelement im Dreh-Bedienteil ein Permanentmagnet, insbesondere mit Magnetisierung mit Nord-Süd-Richtung in einer Richtung parallel zur Drehachse des Dreh-Bedienteils. Dabei können bevorzugt mehrere Magnetelemente als Permanentmagnete im Bedienknebel angeordnet sein. Sie können identisch ausgebildet sein, wodurch der Aufwand reduziert werden kann. Möglicherweise können die Magnetelemente unterschiedlich angeordnet sein, beispielsweise einige, insbesondere die eine Hälfte, mit umgekehrter Magnetisierung als die andere Hälfte. Diese Aufteilung in Hälften kann entsprechend je einem Halbkreis des Dreh-Bedienteils erfolgen, beispielsweise damit der entsprechend magnetisierte Drück-Magnet sich genau korrespondierend dazu ausrichten kann. Diese Ausrichtung kann er dann auch einhalten, unabhängig von einem Eindrücken des Bedienknebels.

In nochmals weiterer Ausgestaltung der Erfindung ist das mindestens eine Magnetelement im Dreh-Bedienteil nahe an einem äußeren Rand des Dreh-Bedienteils angeordnet. Vorteilhaft sind alle Magnetelemente im Dreh-Bedienteil so angeordnet, vorteilhaft entlang einem Kreis, durch dessen Mittelpunkt die Drehachse verläuft. Die Magnetelemente können einen Abstand zueinander aufweisen, wobei dieser nicht immer gleich sein muss zwischen diesen.

In nochmals weiterer Ausgestaltung der Erfindung ist die Feder, gegen die der Bedienknebel eingedrückt werden kann, ringförmig ausgebildet. Ein Mittelpunkt kann auf der Drehachse liegen bzw. mit ihr zusammenfallen. Die Feder liegt vorteilhaft relativ weit außen nahe einem Außenrand des Bedienknebels, wodurch ihre Federwirkung gleichmäßiger sein kann. Die Feder ist vorteilhaft als eine Wellfeder ausgebildet, wobei sie zwei spiegelsymmetrisch gewellte Ringe aus federelastischem Material aufweisen kann, die eine Spiegelebene senkrecht zur Drehachse aufweisen. Alternativ könnten auch mehrere kleinere Federn im Kreis verteilt angeordnet sein.

Bevorzugt ist der Drück-Magnet in einer Ausnehmung angeordnet, die in etwa seiner Form entspricht, also beispielsweise kreisringförmig ist. Zusätzlich oder alternativ kann er auf einem Vorsprung der Basishalterung sitzend angeordnet sein, wobei bevorzugt dieser Vorsprung als eine Art Drehlagerung ausgebildet ist. Eine Abdeckung, vorteilhaft nach Art eines Deckels odgl., kann den Drück-Magnet in der Ausnehmung haltern. Sie kann insbesondere als runder Deckel ausgebildet sein, ggf. mit einem abstehenden und übergreifenden Rand. Dieser Deckel kann den Drück-Magnet wasserdicht nach außen abdecken, wobei er natürlich seine leichtgängige Drehbarkeit behalten sollte.

Vorteilhaft kann der Magnetfeldsensor im Fest-Bedienteil angeordnet und dabei drehfest gehalten sein, besonders vorteilhaft von der Basishalterung. Der Magnetfeldsensor soll sich also nicht mitdrehen müssen oder vorteilhaft nicht mitdrehen können, da eine relative Drehung zu den drehbaren Magnetelementen erkannt werden können soll, er soll nur mit dem eindrückbaren Teil des Bedienknebels auf den Drück-Magnet zu bewegt werden können.

In Ausgestaltung der Erfindung ist der Bedienknebel zweiteilig ausgebildet mit dem Fest-Bedienteil als Innenteil, das drehfest von der Basishalterung gehalten ist bzw. von dieser am Drehen gehindert ist, vorteilhaft durch einen Formschluss wie beispielsweise abstehende Haltezungen odgl.. Um den Fest-Bedienteil herum ist der demgegenüber drehbare Dreh-Bedienteil als Betätigungsring vorgesehen, der mit seinem Außenrand einen Außenrand des Bedienknebels bilden kann, der also durch eine Bedienperson zum Drehen gegriffen werden kann. Das mindestens eine Magnetelement ist dabei im oder am Dreh-Bedienteil gehalten, da es sich ja drehen können soll.

In weiterer Ausgestaltung der Erfindung weist der Bedienknebel nur den drehbaren Dreh-Bedienteil und den Fest-Bedienteil auf, also nur zwei Teile. Diese wiederum weisen natürlich mehrere Komponenten bzw. Funktionseinheiten auf. Vorteilhaft ist der gesamte Bedienknebel eindrückbar auf die Basishalterung zu, also Dreh-Bedienteil und Fest-Bedienteil gemeinsam. Dies ist eine möglichst einfache Ausgestaltung, die dann natürlich auch leichter wasserdicht sein kann. Alternativ ist es aber auch möglich, dass nur ein Teil des Bedienknebels eingedrückt werden kann, beispielsweise der Fest-Bedienteil. Dies ist besonders dann von Vorteil, wenn der Magnetfeldsensor darin angeordnet ist.

Der Bedienknebel kann vorteilhaft mit der Basishalterung eine Baueinheit bilden, also zusammen mit dieser oder mittels dieser ortsfest angeordnet bzw. befestigt werden, beispielsweise an einer Wand. Dazu kann an der Rückseite der Basishalterung ein formschlüssiges Befestigungsmittel odgl. vorgesehen sein, beispielsweise um sie in einen Wandhalter einzuhängen.

In nochmals weiterer Ausgestaltung der Erfindung weist der Fest-Bedienteil eine Anzeige aufweist, die vorzugsweise als Leuchtanzeige ausgebildet sein kann. Diese kann LED aufweisen, die auf bekannte Art und Weise angeordnet werden können und leuchten können. Es können auch hinterleuchtete Displays sein, beispielsweise mit TFT-Technik.

Der Magnetfeldsensor kann als Baueinheit ausgebildet sein mit weiteren Magnetfeldsensoren zusammen, um eine Drehung des Dreh-Bedienteils relativ zu der Basishalterung erkennen zu können. Er kann vorteilhaft als 3D-Magnetfeldsensor bzw. als 3D-Hallsensor ausgebildet sein, wie sie aus dem Stand der Technik an sich bekannt sind. Sie können Änderungen eines Magnetfelds in verschiedenen Richtungen bzw. mit verschiedenen Magnetisierungsrichtungen messen. Eine solche Baueinheit kann eine gemeinsame Anschlusseinrichtung aufweisen.

Bevorzugt ist im Bedienknebel eine Signalauswertung für den Magnetfeldsensor vorgesehen, die einen integrierten Schaltkreis aufweisen kann, vorteilhaft einen Controller oder Microcontroller. Diese Signalauswertung kann auf übliche Art und Weise ausgebildet sein, insbesondere eben für 3D-Magnetfeldsensor bzw. 3D-Hallsensoren. Die Signalauswertung selbst kann eine Sendeeinrichtung aufweisen zum drahtlosen Senden bzw. Übertragen der Daten bzgl. der erkannten Drehstellung und/oder Drückstellung des Bedienknebels relativ zur Basishalterung an eine Steuerung zur Ansteuerung der wasserführenden sanitären Armatur. Alternativ kann diese Sendeeinrichtung separat in der Bedienvorrichtung bzw. im Bedienknebel vorgesehen sein. Verschiedene allgemein bekannte und geeignete Standards m drahtlosen Senden bzw. Übertragen der Daten können verwendet werden.

Der Bedienknebel weist vorteilhaft eine eigene Energieversorgung auf, vorzugsweise einen Akkumulator. Ein solcher Akkumulator ist bevorzugt im Fest-Bedienteil angeordnet. Er kann bei abgenommenem Bedienknebel geladen werden, vorzugsweise induktiv, wie dies bekannt ist. Dazu kann eine entsprechende Spule im Bedienknebel vorgesehen sein. Dann werden keine elektrischen Kontakte benötigt, die bei der feuchten Umgebung der Bedienvorrichtung in einer Dusche odgl. korrodieren könnten und somit Probleme verursachen könnten.

Vorteilhafte Ausführungsbeispiele der Erfindung sind in den Zeichnungen dargestellt. Diese und weitere vorteilhafte Ausführungsformen der Erfindung werden nach folgend beschrieben. Hierbei zeigen:
- Fig. 1: eine schematische Darstellung einer Bedienvorrichtung, die in eine Dusche eingebaut ist,
- Fig. 2: eine schräge Ansicht von der Seite auf die erfindungsgemäße Bedienvorrichtung mit einer befestigbaren Basishalterung, an der ein Bedienknebel angeordnet ist,
- Fig. 3: Basishalterung und Bedienknebel der Bedienvorrichtung aus Fig. 2 in Explosionsdarstellung,
- Fig. 4a und 4b: die Explosionsdarstellung der Fig. 3 in Vergrößerung aufgeteilt auf zwei Darstellungen und
- Fig. 5: eine Schnittdarstellung durch die Bedienvorrichtung der Fig. 2.

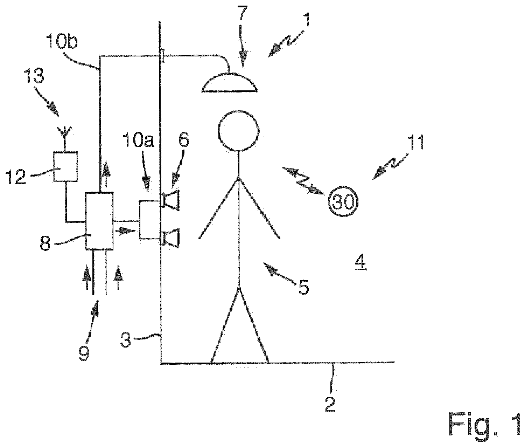

In der Fig. 1 ist eine an sich übliche Dusche 1 gezeigt mit einem Boden 2 und einer linken Wand 3 sowie einer rechten Wand 4. Eine Bedienperson 5 steht in der Dusche 1 und kann zwei Seitenbrausen 6 und/oder eine Kopfbrause 7 an der linken Wand 3 nutzen. Natürlich könnten noch mehr Brausen odgl. vorgesehen sein. Gespeist werden diese Brausen von einer hinter oder in der Wand angebrachten sanitären Armatur 8, die vorteilhaft Thermostatfunktion und Ventil- bzw. Verteilfunktion aufweist. In die sanitäre Armatur 8 führen zwei Zuleitungen 9, wie üblich eine für kaltes Wasser und eine für heißes Wasser. Heraus führen Zuführleitungen 10a zu den Seitenbrausen 6 und 10b zur Kopfbrause 7.

Bedienen kann die Bedienperson 5 die sanitäre Armatur 8 mittels einer an der rechten Wand 4 angeordneten Bedienvorrichtung 11 gemäß der Erfindung, und zwar durch Drehen und/oder Drücken. Die Bedienvorrichtung 11 funkt die durch ihre Bedienung erzeugten Signale an eine Ansteuerung 12 mit einer Antenne 13. Die Ansteuerung 12 ist mit der sanitären Armatur 8 verbunden und steuert diese entsprechend an, vorteilhaft auf an sich bekannte Art und Weise mittels Stellmotoren, Stellventilen und Elektromagneten oder dergleichen. So kann die Bedienperson 5 mittels der Bedienvorrichtung 11 beispielsweise das Wasser zwischen Seitenbrausen 6 und Kopfbrause 7 verteilen, einen Wasserfluss überhaupt starten oder stoppen sowie auch eine Temperatur für das Wasser einstellen. Auch dies ist an sich aus dem Stand der Technik bekannt. Die erfindungsgemäße Bedienvorrichtung 11 ist speziell aufgebaut, wie nachfolgend im Detail erläutert wird.

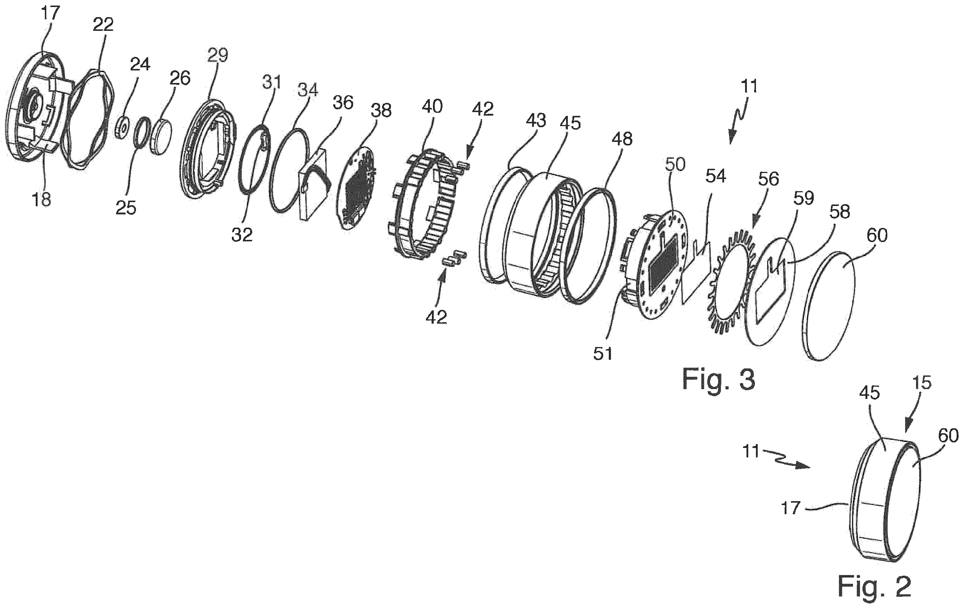

In der Fig. 2 ist eine geschlossene erfindungsgemäße Bedienvorrichtung 11 in schräger Ansicht seitlich von vorne dargestellt. Sie weist einen teilweise drehbaren Bedienknebel 15 auf mit einem außen umlaufenden Betätigungsring 45. An diesem Betätigungsring 45 kann der Bedienknebel 15 gedreht werden, beispielsweise um zwischen verschiedenen Menüpunkten, Einstellungen oder Funktionen zu wählen. Des Weiteren weist der Bedienknebel 15 noch ein Frontglas 60 auf. Daran kann eine Leuchtanzeige vorgesehen sein, die in der Fig. 1 angedeutet als Zahl "30" zu erkennen ist.

An der Rückseite der Bedienvorrichtung 11 ist die Basishalterung 17, welche an einer Wand, beispielsweise an der rechten Wand 4 gemäß Fig. 1, befestigt sein kann oder befestigt werden kann. Sie kann dauerhaft befestigt sein, beispielsweise festgeschraubt oder angeklebt sein. Alternativ kann sie durch Rasten oder Einklipsen an einer nochmals weiteren Halterung ausgebildet sein, die wiederum dauerhaft fest mit der rechten Wand 4 verbunden ist. An der Basishalterung ist der Bedienknebel 15 gehalten.

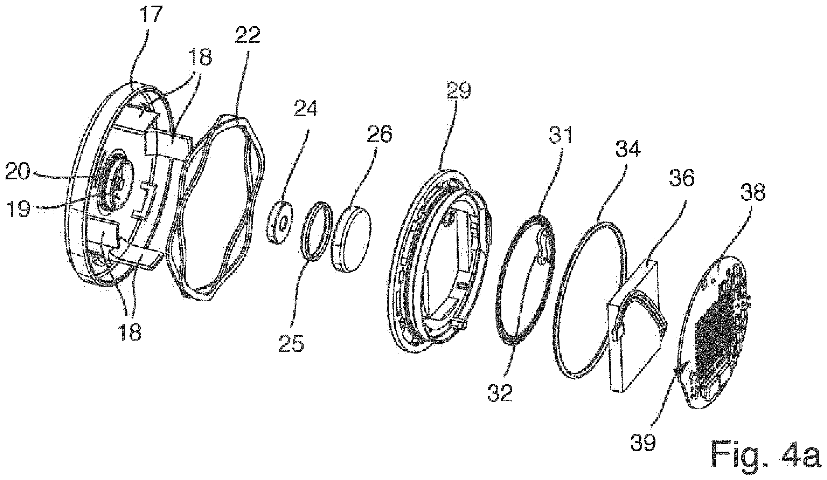

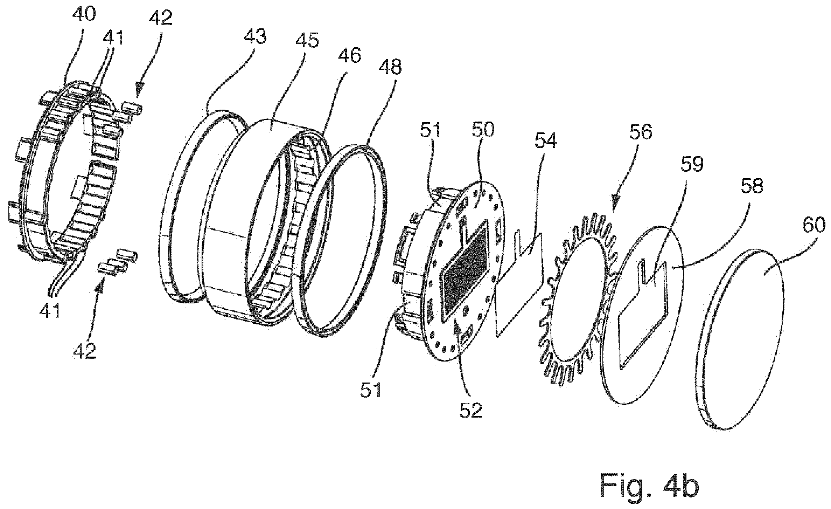

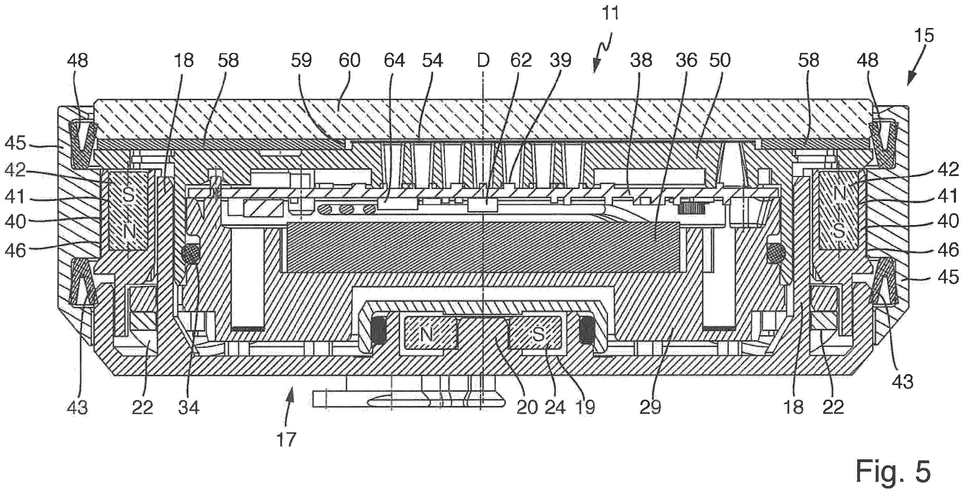

In der gesamten Explosionsdarstellung der Fig. 3 ist links die Basishalterung 17 zu sehen. Es wird auch auf die vergrößerte Darstellung der Fig. 4a und die Schnittdarstellung der Fig. 5 verwiesen. Die Basishalterung 17 ist in etwa schalenartig ausgebildet und weist von einem Boden abstehend vier Halte-Zungen 18 auf. Um diese herum verläuft ein einzulegender Federring 22 entsprechend der vorgenannten Feder, der vorteilhaft als sogenannte Wellfeder ausgebildet ist. Er besteht vorteilhaft aus Kunststoff oder korrosionsfreiem Metall.

Wie die vergrößerten Darstellungen zeigen, ist mittig am Boden der Basishalterung 17 eine ringförmig ausgebildete vertiefte Magnetaufnahme 19 vorgesehen mit einem mittigen abstehenden Vorsprung 20. Hier ist der Drück-Magnet 24 eingelegt, der als Magnetring ausgebildet ist. Er ist diametral magnetisiert in einer Ebene senkrecht zu einer Drehachse, hier dargestellt durch den Nordpol "N" links und den Südpol "S" rechts. Die Magnetaufnahme 19 wird durch einen mit einem Dichtungsring 25 innen versehenen Deckel 26 verschlossen, wenn der Drück-Magnet 24 eingelegt ist. Aus der Darstellung der Fig. 5 ist zu ersehen, dass der Drück-Magnet 24 so viel Spiel um den Vorsprung 20 herum aufweist, dass er sich leicht drehen kann. Hier sind vorteilhaft möglichst glatte Oberflächen für eine leichte Drehbarkeit vorzusehen. Des Weiteren soll sich der Drück-Magnet 24 nur möglichst gering oder besser gar nicht in einer Richtung entlang der strichpunktiert dargestellten Drehachse D bewegen können, so dass er also nahezu am Deckel 26 anliegt.

Der Bedienknebel 15, der in den Explosionsdarstellungen rechts neben dem Deckel 26 beginnt, weist ein Gehäuseunterteil 29 auf. In diesem ist eine Spule 31 mit einem Spulenanschluss 32 vorgesehen, die für ein induktives Laden eines Akkumulators 36 vorgesehen ist. Zur Abdichtung ist ein O-Ring 34 vorgesehen, der auch in der Fig. 5 zu erkennen ist, weil er in einer Ausnehmung außen am Gehäuseunterteil 29 liegt.

Auf den Gehäuseunterteil 29 wird eine Leiterplatte 38 montiert, die unter anderem auf ihrer Oberseite eine Vielzahl von LED 39 aufweist. Diese erzeugen die vorgenannte Leuchtanzeige. An der Unterseite der Leiterplatte 38 ist, vorteilhaft auf der Drehachse D, ein eingangs genannter 3D-Hall-Sensor 62 angeordnet und elektrisch angeschlossen.

Um das Gehäuseunterteil 29 und auch um die Halte-Zungen 18 herum verläuft ein Magnet-Aufnahmering 40, der mehrere, unterschiedlich angeordnete Aufnahmetaschen 41 aufweist. In einigen von diesen Aufnahmetaschen sind Permanentmagnete 42 als vorgenannte Magnetelemente angeordnet, die stabförmig ausgebildet sind. Sie sind gemäß Fig. 5 magnetisiert in einer Richtung parallel zur Drehrichtung D, was in Fig. 5 auch beispielhaft jeweils eingezeichnet ist.

Der außen umgreifende Betätigungsring 45 weist einen unteren Nutring 43 und einen oberen Nutring 48 auf, die als elastische Gummidichtungen ausgebildet sind. Sie dienen zur Abdichtung, wie die Fig. 5 zeigt. Der untere Nutring 43 dichtet den Betätigungsring 45 nach unten gegen den hochstehenden umlaufenden Rand der Basishalterung 17 ab. Der obere Nutring 48 dichtet den Betätigungsring 45 gegen das runde Frontglas 60 ab.

Innerhalb des Betätigungsrings 45 ist ein Gehäuseoberteil 50 vorgesehen. An einem nach unten abragenden flanschartigen Vorsprung davon sind Halte-Ausnehmungen 51 ausgebildet, in die die Halte-Zungen 18 der Basishalterung 17 eingreifen können. Dadurch ist das Gehäuseoberteil 50 drehfest an der Basishalterung 17 gehalten, kann allerdings in Richtung entlang der Drehachse D bewegt werden und somit auch eingedrückt werden, wie nachfolgend noch näher erläutert wird. Vorne an dem Gehäuseoberteil 50 ist eine Art Öffnungsmatrix 52 vorgesehen mit lauter Öffnungen, die jeweils einer der LED 39 entsprechen. Sie können beispielsweise mit Linsen oder sonstigen ähnlichen optischen Einrichtungen versehen sein. Vor der Öffnungsmatrix 52 wird eine Diffusorfolie 54 gelegt oder geklebt für eine bessere optische Darstellung.

Vorne auf dem Gehäuseoberteil 50 liegt eine Sternscheibe 56 auf. Diese wirkt derart zusammen mit den Permanentmagneten 42 am Magnet-Aufnahmering 40, der drehfest mittels Ausnehmungen 46 im Betätigungsring 45 gehalten ist, dass eine Art magnetische Rasterung erreicht wird. So kann ein Drehen des drehbaren Bedienknebels 15 relativ zu dem inneren Teil, nämlich dieser Sternscheibe 56 samt Gehäuseoberteil 50, Gehäuseunterteil 29 und Basishalterung 17, gerastert sein mit einer für die Bedienperson fühlbaren Rasterung entsprechend der Ausgestaltung der Sternscheibe 56. Dies ist an sich aus dem Stand der Technik auch bekannt. Die Sternscheibe 56 wird an der Vorderseite des Gehäuseoberteils 50 mittels eines doppelseitigen Klebepads 58 gehalten, das mit der Unterseite des Frontglases 60 verklebt ist und so auch eine Abdichtung nach vorne sicherstellt.

Der eingangs genannte Dreh-Bedienteil des Bedienknebels 15 wird also hauptsächlich gebildet von dem Betätigungsring 45 mit dem drehfest darin gehaltenen Magnet-Aufnahmering 40. Der eingangs genannte Fest-Bedienteil wird hauptsächlich von den übrigen Teilen des Bedienknebels 15 gebildet, insbesondere dreht sich aufgrund des Eingriffs der Halte-Zungen 18 in die Halte-Ausnahmen 51 das aus den Teilen 29 und 50 bestehende Gehäuse nicht und somit auch nicht die Leuchtanzeige, die von den LED 39 gebildet wird. Somit kann eine Bedienperson 5 auch beim Drehen des Bedienknebels 15 während einer Bedienung der Bedienvorrichtung 11 stets leicht und genau erkennen, was daran angezeigt wird.

Der gesamte Bedienknebel 15 wiederum ist an der Basishalterung 17 gehalten bzw angeordnet, vorteilhaft nur mittels erheblicher Kraft oder Werkzeug entfernbar. Er kann gegenüber dieser eingedrückt werden, und zwar gegen die Kraft des Federrings 22. Der untere Nutring 43, der an der Innenseite des Betätigungsrings 45 gehalten ist, verschiebt sich dabei an der Basishalterung 17 nach unten. Er behält jedoch seine Dichtwirkung, so dass hier kein Wasser eintreten kann. Somit werden auch die Bauteile des Bedienknebels 15, die nicht gedreht werden können, eingedrückt bzw. auf die Basishalterung 17 zu gedrückt. Dadurch bewegt sich auch der 3D-Hall-Sensor 62 auf den Drück-Magnet 24 zu. Der in der Fig. 5 zu erkennende Betätigungsweg, beispielsweise zwischen Unterseite des Gehäuseunterteils 29 unterhalb des Akkumulators 36 und der Oberseite des Deckels 26, kann in der Praxis etwa 0,5 mm bis 1 mm betragen, so dass er deutlich von einer Bedienperson wahrgenommen wird. Dieser relativ gering erscheinende Betätigungsweg kann auch von dem 3D-Hall-Sensor 62 als Annäherung an den Drück-Magnet 24 gut erkannt werden. Des Weiteren kann der 3D-Hall-Sensor 62 auch noch eine Drehung der Permanentmagnete 42 um ihn herum erfassen bezüglich eines Drehwinkels, so dass auch eine Drehbetätigung des Bedienknebels 15 erkannt werden kann. Hierfür sind innerhalb des 3D-Hall-Sensors unterschiedliche einzelne HallSensoren vorgesehen, vorteilhaft einer für die Erkennung der Annäherung an den Drück-Magnet 24 und einer oder zwei weitere, um unterschiedliche Magnetfeldlinien ausgehend von den Permanentmagneten 42 bei Drehung zu erkennen.

Hier ist auch offensichtlich, warum es die Erfindung vorteilhaft schafft, durch die Drehbarkeit des Drück-Magneten 24 eine Genauigkeit einer Erkennung zu verbessern. Durch diese Drehbarkeit des Drück-Magneten 24 ändert sich der Abstand zu dem 3D-Hall-Sensor 62 ja nicht, so dass dieser auch keine Signalveränderung oder Magnetfeldstärkeänderung erkennt, welche er ansonsten als Annäherung an den Drück-Magneten 24 und somit als ein Eindrücken des Bedienknebels entsprechend einem Bedienvorgang durch Drücken erkennen würde. Der Drück-Magnet 24 dreht sich nämlich durch Wechselwirkung mit den Permanentmagneten 42 mit dem Betätigungsring 45 mit, so dass hier ein an sich stets gleiches Magnetfeld zwischen den Magneten 24 und 42 besteht. Es ändert sich in Richtung parallel zur Drehachse D nicht, so dass eben auch keine Annäherung entsprechend einem Eindrücken zum Drück-Magnet 24 erkannt wird. In der Ebene senkrecht zur Drehachse D durch den 3D-Hall-Sensor 62 ändert sich das Magnetfeld natürlich gerade aufgrund der Drehung, so dass diese von dem 3D-Hall-Sensor 62 eben erkannt und ausgewertet werden kann. Der 3D-Hall-Sensor 62 ist auch im Mittelpunkt der Kreisbahn der Permanentmagnete 42 angeordnet, so dass der Abstand immer derselbe ist bzw. gleich bleibt.

An der Unterseite der Leiterplatte 38 ist links neben dem 3D-Hall-Sensor 62 eine Auswertevorrichtung 64 vorgesehen, vorteilhaft ein integrierter Schaltkreis. Diese wertet die Signale des 3D-Hall-Sensors 62 aus und kann somit erkennen, ob sich dieser beim Eindrücken des Bedienknebels 15 gegen die Basishalterung 17 an den Drück-Magnet 24 angenähert hat. Ebenso kann die Auswertevorrichtung 64 erkennen, ob der Betätigungsring 45 mit den Permanentmagneten 42 im Magnet-Aufnahmering 40 um den nicht-drehbaren 3D-Hall-Sensor 62 herum gedreht worden ist. Beide Bewegungen kann die Auswertevorrichtung 64 genau erkennen und dann mittels einer nicht dargestellten Sendeeinrichtung, die vorteilhaft ebenfalls an der Leiterplatte 38 vorgesehen ist, an die Antenne 13 der Ansteuerung 12 senden. Hier können verschiedene Funkstandards vorgesehen sein, beispielsweise Bluetooth bzw. BLE, Zigbee, WiFi oder sonstige.

Das drahtlose induktive Laden des Akkumulators 36 ist möglich, wenn die Bedienvorrichtung 11 auf eine entsprechende Ladestation gelegt wird. Dies ist ja von Mobiltelefonen bekannt.

Der 3D-Hall-Sensor 62 könnte in Fig. 5 auch anstelle über dem Akkumulator 36 darunter angeordnet sein, also zwischen Akkumulator 36 und Gehäuseunterteil 29, natürlich wiederum auf der Drehachse D liegend. Dann stört der Akkumulator 36 die Magnetfelderkennung nicht, was die Genauigkeit verbessert. Dabei kann der 3D-Hall-Sensor 62 dann auf einer flexiblen Leiterplatte oder dergleichen angeordnet und elektrisch angeschlossen sein, die von der Leiterplatte 38 aus seitlich um den Akkumulator 36 herum nach unten geführt ist. Mittels einer passgenauen Vertiefung in der Oberseite des Gehäuseunterteils 29 kann er genau auf der Drehachse D und mit gleichbleibendem Abstand zum Drück-Magnet 24 positioniert werden.

## Patentansprüche

1. Bedienvorrichtung (11) für eine wasserführende sanitäre Armatur (8), wobei die Bedienvorrichtung (11) aufweist:
- eine ortsfest befestigbare Basishalterung (17),
- einen an der Basishalterung (17) angeordneten Bedienknebel (15), der mindestens zwei Teile aufweist, nämlich mindestens ein Dreh-Bedienteil und mindestens ein Fest-Bedienteil, wobei Dreh-Bedienteil und Fest-Bedienteil gegeneinander verdrehbar sind,
wobei:
- zumindest der Dreh-Bedienteil des Bedienknebels (15) ist drehbar um eine Drehachse (D),
- zumindest ein Teil des Bedienknebels (15) ist aus einer Grund-Stellung entlang der Drehachse (D) gegen eine Federkraft einer Feder (22) eindrückbar auf die Basishalterung (17) zu in eine Eindrück-Stellung,
- die Feder (22) drückt den Bedienknebel (15) mit der Federkraft von der Eindrück-Stellung in die Grund-Stellung,
- in der Basishalterung (17) ist mindestens ein Drück-Magnet (24) angeordnet,
- im eindrückbaren Teil des Bedienknebels (15) ist mindestens ein Magnetfeldsensor (62) angeordnet,
- eine Auswertevorrichtung (64) ist für den Magnetfeldsensor (62) vorgesehen, die dazu ausgebildet ist, um zu erkennen, ob sich der Magnetfeldsensor (62) beim Eindrücken des eindrückbaren Teils des Bedienknebels (15) an den Drück-Magnet (24) annähert,
- im Dreh-Bedienteil des Bedienknebels (15) ist mindestens ein Magnetelement (42) angeordnet,
- der Drück-Magnet (24) drehbar gelagert ist um die Drehachse (D) des Dreh-Bedienteils des Bedienknebels (15),
- der Drück-Magnet (24) mit dem Magnetelement (42) derart wechselwirkt, dass sich der Drück-Magnet (24) mit einer Drehung des Magnetelements (42) samt dem Dreh-Bedienteil des Bedienknebels (15) mitdreht.

2. Bedienvorrichtung nach Anspruch 1, **dadurch gekennzeichnet, dass** der Drück-Magnet (24) rotationssymmetrisch ausgebildet ist, insbesondere als Scheibe oder als Kreisring ausgebildet ist, wobei vorzugsweise die Drehachse (D) durch einen Mittelpunkt und Rotationssymmetriepunkt des Drück-Magneten (24) verläuft.

3. Bedienvorrichtung nach einem der vorhergehenden Ansprüche, **dadurch gekennzeichnet, dass** der Drück-Magnet (24) in Richtung entlang der Drehachse (D) maximal 1 mm bzw. 25% des Bewegungswegs des Bedienknebels (15) beim Drücken auf die Basishalterung (17) zu bewegbar ist, wobei vorzugsweise der Drück-Magnet (24) in Richtung entlang der Drehachse (D) nicht bewegbar ist.

4. Bedienvorrichtung nach einem der vorhergehenden Ansprüche, **dadurch gekennzeichnet, dass** der Drück-Magnet (24) diametral magnetisiert ist mit Nord-Süd-Richtung in einer Richtung senkrecht zur Drehachse (D).

5. Bedienvorrichtung nach einem der vorhergehenden Ansprüche, **dadurch gekennzeichnet, dass** das Magnetelement im Dreh-Bedienteil ein Permanentmagnet (42) ist, insbesondere mit Nord-Süd-Richtung in einer Richtung parallel zur Drehachse (D), wobei vorzugsweise mehrere Magnetelemente im Bedienknebel (15) angeordnet sind.

6. Bedienvorrichtung nach Anspruch 5, **dadurch gekennzeichnet, dass** das mindestens eine Magnetelement (42) im Dreh-Bedienteil, vorzugsweise alle Magnetelemente (42), nahe an einem äußeren Rand des Dreh-Bedienteils angeordnet sind, vorzugsweise entlang einem Kreis, durch dessen Mittelpunkt die Drehachse (D) verläuft.

7. Bedienvorrichtung nach einem der vorhergehenden Ansprüche, **dadurch gekennzeichnet, dass** die Feder (22) ringförmig verläuft, vorzugweise mit einem Mittelpunkt auf der Drehachse (D), wobei vorzugsweise die Feder (22) eine Wellfeder ist aus zwei spiegelsymmetrisch gewellten Ringen aus federelastischem Material mit Spiegelebene senkrecht zur Drehachse (D).

8. Bedienvorrichtung nach einem der vorhergehenden Ansprüche, **dadurch gekennzeichnet, dass** der Drück-Magnet (24) in einer seiner Form entsprechenden Ausnehmung angeordnet ist und/oder auf einem Vorsprung (20) der Basishalterung (17) sitzend angeordnet ist, wobei vorzugsweise eine wasserdichte Abdeckung, insbesondere als runder Deckel (26), den Drück-Magnet (24) haltert und wasserdicht abdeckt nach außen.

9. Bedienvorrichtung nach einem der vorhergehenden Ansprüche, **dadurch gekennzeichnet, dass** der Magnetfeldsensor (62) im Fest-Bedienteil angeordnet ist und drehfest gehalten ist von der Basishalterung (17), wobei vorzugsweise der Bedienknebel (15) zweiteilig ausgebildet ist mit dem Fest-Bedienteil als Innenteil, das drehfest von der Basishalterung (17) gehalten ist, wobei um den Fest-Bedienteil der demgegenüber drehbare Dreh-Bedienteil als Betätigungsring (45) vorgesehen ist, der mit seinem Außenrand einen Außenrand des Bedienknebels (15) bildet.

10. Bedienvorrichtung nach Anspruch 9, **dadurch gekennzeichnet, dass** das mindestens eine Magnetelement (42) im oder am Dreh-Bedienteil gehalten ist.

11. Bedienvorrichtung nach einem der vorhergehenden Ansprüche, **dadurch gekennzeichnet, dass** der Bedienknebel (15) nur den drehbaren Dreh-Bedienteil und den Fest-Bedienteil aufweist, wobei der gesamte Bedienknebel (15) eindrückbar ist.

12. Bedienvorrichtung nach einem der vorhergehenden Ansprüche, **dadurch gekennzeichnet, dass** der Fest-Bedienteil eine Anzeige aufweist, vorzugsweise als Leuchtanzeige (39).

13. Bedienvorrichtung nach einem der vorhergehenden Ansprüche, **dadurch gekennzeichnet, dass** der Magnetfeldsensor (62) als Baueinheit ausgebildet ist mit weiteren Magnetfeldsensoren zur Erkennung einer Drehung des Dreh-Bedienteils relativ zu der Basishalterung (17), wobei vorzugsweise die Baueinheit eine gemeinsame Anschlusseinrichtung aufweist, wobei insbesondere der Magnetfeldsensor als 3D-Magnetfeldsensor bzw. als 3D-Hallsensor (62) ausgebildet ist.

14. Bedienvorrichtung nach einem der vorhergehenden Ansprüche, **dadurch gekennzeichnet, dass** der Bedienknebel (15) eine eigene Energieversorgung aufweist, insbesondere einen Akkumulator (36), wobei vorzugsweise der Akkumulator (36) im Fest-Bedienteil angeordnet ist.

## Claims

1. Operator control device (11) for a water-conducting sanitary fitting (8), the operator control device (11) comprising:
- a basic holder (17) fastenable to be fixed in location,
- an operating toggle (15) disposed on the basic holder (17), which toggle is composed of at least two parts, namely at least one rotating operating part and at least one fixed operating part, wherein rotating operating part and fixed operating part are rotatable in relation to each other,
wherein:
- at least the rotating operating part of the operating toggle (15) is rotatable about a rotation axis (D),
- at least one part of the operating toggle (15) can be pushed in towards the basic holder (17) to a pushed-in position from a normal position along the rotation axis (D) against a spring force of a spring (22),
- the spring (22) urges the operating toggle (15) with the spring force from the pushed-in position to the normal position,
- at least one pusher magnet (24) is disposed in the basic holder (17),
- at least one magnetic field sensor (62) is disposed in the part of the operating toggle (15) that can be pushed in,
- an evaluation device (64) for the magnetic field sensor (62) is provided, which evaluation device is configured to detect whether the magnetic field sensor (62) approaches the pusher magnet (24) during pushing-in of the pushable part of the operating toggle (15),
- at least one magnetic element (42) is disposed in the rotating operating part of the operating toggle (15),
- the pusher magnet (24) is rotatably mounted for rotation about the rotation axis (D) of the rotating operating part of the operating toggle (15),
- the pusher magnet (24) is operable for interaction with the magnetic element (42) such that the pusher magnet (24) co-rotates upon rotation of the magnetic element (42) together with the rotating operating part of the operating toggle (15).

2. Operator control device according to claim 1, **characterized in that** the pusher magnet (24) has a rotation-symmetric design, preferably is a disk or a circular ring, wherein it is preferred that the rotation axis (D) extends through a center point and rotation-symmetry point of the pusher magnet (24).

3. Operator control device according to any one of the preceding claims, **characterized in that** the pusher magnet (24), in the direction along the rotation axis (D), is movable at a maximum of 1 mm or 25 % of the movement path of the operating toggle (15) during pushing towards the basic holder (17), wherein preferably the pusher magnet (24) is not movable in the direction along the rotation axis (D).

4. Operator control device according to any one of the preceding claims, **characterized in that** the pusher magnet (24) is diametrically magnetized with the north-south direction in a direction perpendicular to the rotation axis (D).

5. Operator control device according to any one of the preceding claims, **characterized in that** the magnetic element in the rotating operating part is a permanent magnet (42), preferably with the north-south direction in a direction parallel to the rotation axis (D), wherein it is preferred that a plurality of magnetic elements are disposed in the operating toggle (15).

6. Operator control device according to claim 5, **characterized in that** the at least one magnetic element (42) in the rotating operating part, preferably all of the magnetic elements (42), are disposed in the vicinity of an outer edge of the rotating operating part, preferably along a circle, with the rotation axis (D) passing through the center point thereof.

7. Operator control device according to any one of the preceding claims, **characterized in that** the spring (22) extends in a ring shape, preferably with a center point on the rotation axis (D), wherein preferably the spring (22) is an ondular washer composed of two mirror-symmetrically ondulated rings made of spring-elastic material with a mirror plane perpendicular to the rotation axis (D).

8. Operator control device according to any one of the preceding claims, **characterized in that** the pusher magnet (24) is disposed in a recess corresponding to its shape and/or is disposed sitting on a projection (20) of the basic holder (17), wherein preferably a water-tight cover, preferably a round lid (26), holds the pusher magnet (24) and covers it in a water-tight manner towards the outside.

9. Operator control device according to any one of the preceding claims, **characterized in that** the magnetic field sensor (62) is disposed in the fixed operating part and non-rotatably retained by the basic holder (17), wherein preferably the operating toggle (15) is composed of two parts, with the fixed operating part as an interior part which is non-rotatably retained by the basic holder (17), wherein the rotating operating part which is rotatable in relation to the fixed operating part is provided as an actuation ring (45) around the fixed operating part, the outer edge of said actuation ring forming an outer edge of the operating toggle (15).

10. Operator control device according to claim 9, **characterized in that** the at least one magnetic element (42) is retained in or on the rotating operating part.

11. Operator control device according to any one of the preceding claims, **characterized in that** the operating toggle (15) includes only the rotatable rotating operating part and the fixed operating part, wherein the entire operating toggle (15) can be pushed in.

12. Operator control device according to any one of the preceding claims, **characterized in that** the fixed operating part includes a display, preferably an illuminated display (39).

13. Operator control device according to any one of the preceding claims, **characterized in that** the magnetic field sensor (62) is an assembly unit having further magnetic field sensors for detecting a rotation of the rotating operating part relative to the basic holder (17), wherein preferably the assembly unit has a common connector device, wherein it is preferred that the magnetic field sensor is a 3D magnetic field sensor or a 3D Hall-effect sensor (62).

14. Operator control device according to any one of the preceding claims, **characterized in that** in the operating toggle (15) has a distinct energy supply, preferably a battery pack (36), wherein it is preferred that the battery pack (36) is disposed in the fixed operating part.

## Revendications

1. Arrangement de commande (11) pour un élément de robinetterie (8) sanitaire de conduite d'eau, l'arrangement de commande (11) possédant :
- un support de base (17) pouvant être fixé en position fixe,
- une manette de commande (15) disposée sur le support de base (17), laquelle possède au moins deux parties, à savoir au moins une partie de commande rotative et au moins une partie de commande fixe, la partie de commande rotative et la partie de commande fixe pouvant tourner l'une par rapport à l'autre,
- au moins la partie de commande rotative de la manette de commande (15) pouvant tourner autour d'un axe de rotation (D),
- au moins une partie de la manette de commande (15) pouvant être enfoncée sur le support de base (17), depuis une position de base le long de l'axe de rotation (D) contre une force de ressort d'un ressort (22), fermée dans une position enfoncée,
- le ressort (22) poussant la manette de commande (15) avec la force de ressort de la position enfoncée dans la position de base,
- au moins un aimant de poussée (24) étant disposé dans le support de base (17),
- au moins un capteur de champ magnétique (62) étant disposé dans la partie enfonçable de la manette de commande (15),
- un arrangement d'interprétation (64) étant présent pour le capteur de champ magnétique (62), lequel est configuré pour reconnaître si le capteur de champ magnétique (62) se rapproche de l'aimant de poussée (24) lors de l'enfoncement de la partie enfonçable de la manette de commande (15),
- au moins un élément magnétique (42) étant disposé dans la partie de commande rotative de la manette de commande (15),
- l'aimant de poussée (24) étant disposé de manière rotative autour de l'axe de rotation (D) de la partie de commande rotative de la manette de commande (15),
- l'aimant de poussée (24) coopérant avec l'élément magnétique (42) de telle sorte que l'aimant de poussée (24) accompagne en rotation une rotation de l'élément magnétique (42) avec la partie de commande rotative de la manette de commande (15).

2. Arrangement de commande selon la revendication 1, **caractérisé en ce que** l'aimant de poussée (24) est de configuration à symétrie rotationnelle, notamment réalisé sous la forme d'un disque ou d'un anneau circulaire, l'axe de rotation (D) suivant de préférence un tracé à travers un centre et un point de symétrie de rotation de l'aimant de poussée (24).

3. Arrangement de commande selon l'une des revendications précédentes, **caractérisé en ce que** l'aimant de poussée (24), lors d'une pression sur le support de base (17), peut se déplacer dans la direction le long de l'axe de rotation (D) au maximum de 1 mm ou 25 % de la course de déplacement de la manette de commande (15), l'aimant de poussée (24) ne pouvant de préférence pas se déplacer dans la direction le long de l'axe de rotation (D).

4. Arrangement de commande selon l'une des revendications précédentes, **caractérisé en ce que** l'aimant de poussée (24) est magnétisé diamétralement, avec la direction Nord-Sud dans une direction perpendiculaire à l'axe de rotation (D) .

5. Arrangement de commande selon l'une des revendications précédentes, **caractérisé en ce que** l'élément magnétique dans la partie de commande rotative est un aimant permanent (42), notamment avec la direction Nord-Sud dans une direction parallèle à l'axe de rotation (D), plusieurs éléments magnétiques étant de préférence disposés dans la manette de commande (15).

6. Arrangement de commande selon la revendication 5, **caractérisé en ce que** l'au moins un élément magnétique (42) dans la partie de commande rotative, de préférence tous les éléments magnétiques (42) sont disposés proches d'un bord extérieur de la partie de commande rotative, de préférence le long d'un cercle par le centre duquel passe l'axe de rotation (D) .

7. Arrangement de commande selon l'une des revendications précédentes, **caractérisé en ce que** le ressort (22) suit un tracé annulaire, de préférence avec un centre sur l'axe de rotation (D), le ressort (22) étant de préférence un ressort ondulé composé de deux anneaux ondulés à symétrie en miroir en un matériau flexible avec le plan de miroir perpendiculaire à l'axe de rotation (D).

8. Arrangement de commande selon l'une des revendications précédentes, **caractérisé en ce que** l'aimant de poussée (24) est disposé dans une cavité correspondant à sa forme et/ou est disposé reposant sur une partie saillante (20) du support de base (17), de préférence un recouvrement étanche à l'eau, en particulier sous la forme d'un couvercle rond (26), maintenant l'aimant de poussée (24) et le recouvrant de manière étanche à l'eau par rapport à l'extérieur.

9. Arrangement de commande selon l'une des revendications précédentes, **caractérisé en ce que** le capteur de champ magnétique (62) est disposé dans la partie de commande fixe et est maintenu solidaire en rotation par le support de base (17), la manette de commande (15) étant de préférence réalisée en deux parties avec la partie de commande fixe en tant que partie interne, laquelle est maintenue solidaire en rotation par le support de base (17), la partie de commande rotative étant présente autour de la partie de commande fixe, en pouvant tourner par rapport à celle-ci, sous la forme d'une bague d'actionnement (45) qui, avec son côté extérieur, forme un côté extérieur de la manette de commande (15).

10. Arrangement de commande selon la revendication 9, **caractérisé en ce que** l'au moins un élément magnétique (42) est maintenu dans ou sur la partie de commande rotative.

11. Arrangement de commande selon l'une des revendications précédentes, **caractérisé en ce que** la manette de commande (15) ne possède que la partie de commande rotative et la partie de commande fixe, la totalité de la manette de commande (15) pouvant être enfoncée.

12. Arrangement de commande selon l'une des revendications précédentes, **caractérisé en ce que** la partie de commande fixe possède un indicateur, de préférence sous la forme d'un indicateur lumineux (39).

13. Arrangement de commande selon l'une des revendications précédentes, **caractérisé en ce que** le capteur de champ magnétique (62) est réalisé sous la forme d'un module avec des capteurs de champ magnétique supplémentaires destinés à reconnaître une rotation de la partie de commande rotative par rapport au support de base (17), le module possédant de préférence un dispositif de raccordement commun, le capteur de champ magnétique étant de préférence réalisé sous la forme d'un capteur de champ magnétique 3D ou d'un capteur à effet Hall 3D (62).

14. Arrangement de commande selon l'une des revendications précédentes, **caractérisé en ce que** la manette de commande (15) possède une alimentation en énergie propre, notamment un accumulateur (36), l'accumulateur (36) étant de préférence disposé dans la partie de commande fixe.
